# EUROPEAN PATENT APPLICATION

(11) **EP 2 113 810 A1**
(43) Date of publication of application: **04.11.2009**
(21) Application number: 08711874.1
(22) Date of filing: 18.02.2008
(51) Int. Cl.: G03F 7/023, C08G 73/06, H01L 21/027, H01L 21/312

(54) **PHOTOSENSITIVE RESIN COMPOSITION, CURED FILM, PROTECTIVE FILM, INSULATING FILM AND SEMICONDUCTOR DEVICE USING THE SAME, AND DISPLAY DEVICE**

(30) Priority: 19.02.2007 JP 2007037278
(71) Applicant: Sumitomo Bakelite Co., Ltd., Shinagawa-ku Tokyo 140-0002 (JP)
(72) Inventor: MAKABE, Hiroaki, Tokyo 140-0002 (JP); TERAKAWA, Koji, Tokyo 140-0002 (JP)
(74) Representative: Müller-Boré & Partner Patentanwälte
(86) International application number: PCT/JP2008/053110
(87) International publication number: WO 2008/102890

(57) **Abstract**

A photosensitive resin composition includes an alkali-soluble resin having a polybenzoxazol precursor structure or a polyimide precursor structure, or both, and a photosensitizer, the alkali-soluble resin having a ratio ([A]/[B]) of a cyclization rate [A] (%) at 250°C to a cyclization rate [B] (%) at 300°C of 0.70 or more. According to the present invention, a photosensitive resin composition which is highly sensitive and has high productivity in the manufacture of semiconductor devices, a cured film, a protective film, an insulating film, and a semiconductor device and a display device using the cured film can be provided.

## Description

### TECHNICAL FIELD

The present invention relates to a photosensitive resin composition, a cured film, a protective film, and an insulating film, and a semiconductor device and a display device using the same.

### BACKGROUND ART

A polyimide resin having excellent heat resistance, superior electrical and mechanical properties, and the like and a polybenzoxazole resin which has excellent moisture resistance in addition to excellent properties possessed by the polyimide resin have generally been used as a surface protective film and an insulating film of semiconductor elements. A photosensitive resin composition comprising a polyimide resin, a polybenzoxazole resin, and a precursor of these resins which are provided with photosensitivity and the capability of being processed by a relief pattern preparation process of which a part is simplified has been developed. The resin composition has high heat resistance, excellent electric and mechanical properties, and exhibits an effect of increasing the yield (productivity) while maintaining high sensitivity and capability of being finely processed by microfabrication. The photosensitive resin composition has a possibility of being used not only as a resin composition for producing a protective film of semiconductor elements, but also as an insulation resin composition.

More recently, a positive-type photosensitive resin composition which can be developed using an alkaline aqueous solution has been developed from the viewpoint of safety. For example, Patent Document 1 discloses a positive-type photosensitive resin composition which comprises a polybenzoxazole precursor as an alkali-soluble resin and a diazoquinone compound as a sensitizer. The development mechanism of the positive-type photosensitive resin composition is as follows. If the positive-type photosensitive resin composition is irradiated with an actinic ray through a mask with a desired pattern, the diazoquinone compound in the exposed areas undergoes a chemical change and becomes soluble in an alkaline aqueous solution, thereby promoting dissolution of the alkali-soluble resin. On the other hand, the diazoquinone compound in the unexposed area is insoluble in an alkaline aqueous solution and provides the alkali-soluble resin with resistance to the alkaline aqueous solution as a result of an interaction therewith. A relief film pattern consisting only of the unexposed area may be prepared by removing the exposed area by dissolution using the solubility difference of the exposed area and unexposed area patterning.

The polyimide precursor resin or a polybenzoxazole precursor resin in the photosensitive resin composition from which the relief pattern has been formed is cyclized by dehydration when cured at a temperature of about 300 to 350°C, whereby the precursor resin ultimately turns into a polyimide resin or a polybenzoxazole resin having high heat resistance. Remarkable miniaturization and high integration of semiconductor elements in recent years have reduced heat resistance, particularly of storage elements. In order to increase the productivity, a polyimide precursor resin or a polybenzoxazole precursor resin which can be cured at a lower temperature is demanded.

In order to cure resins, an oven, a hot plate, an electric furnace, an infrared radiation, a microwave, and the like are used. In the case of an oven, for example, the temperature differs according to the position (e.g. upper step, lower step, corner, etc.) in the oven. The resin is not necessarily uniformly heated to a set temperature.

In this case, the degree of curing of the wafer to which the photosensitive resin composition has been applied varies according to points on the wafer plane and between the wafers, resulting in fluctuation of performance. The productivity may decrease due to the fluctuation of the performance. Furthermore, since the difference is remarkable when cured at a low temperature, the productivity is further decreased.

Therefore, development of a photosensitive resin composition which has high productivity when cured at a broad range of temperatures has been strongly desired. Patent Document 1: JP-B-1-46862

Therefore, an object of the present invention is to provide a photosensitive resin composition which is highly sensitive and has high productivity in the manufacture of semiconductor devices, a cured film, a protective film, and an insulating film, as well as a semiconductor device and a display device using the cured film.

### DISCLOSURE OF THE INVENTION

According to the present invention, the above object can be attained by a photosensitive resin composition, a cured film, a protective film, an insulating film, a semiconductor device, and a display device defined in (1) to (9) given below.
(1) A photosensitive resin composition comprising an alkali-soluble resin (I) having a polybenzoxazol precursor structure or a polyimide precursor structure, or both, and a photosensitizer (II), the alkali-soluble resin having a ratio ([A]/[B]) of a cyclization rate [A] (%) at 250°C to a cyclization rate [B] (%) at 300°C of 0.70 or more.
(2) The photosensitive resin composition according to (1), wherein the cyclization rate of the alkali-soluble resin at 250°C is 70% or more.
(3) The photosensitive resin composition according to (1) or (2), wherein a film obtained by coating the alkali-soluble resin and drying the coating has a transmittance of light at a wavelength of 365 nm of 40% or more per 5 µm of the film thickness.
(4) A cured film comprising a cured product of the photosensitive resin composition according to any one of (1) to (3).
(5) The cured film according to (4), the cured film having a glass transition temperature (Tg) of 250°C or more.
(6) A protective film comprising the cured film according to (4) or (5).
(7) An insulating film comprising the cured film according to (4) or (5).
(8) A semiconductor device comprising the cured film according to (4) or (5).
(9) A display device comprising the cured film according to (4) or (5).

According to the present invention, a photosensitive resin composition which is highly sensitive and has high productivity in the manufacture of semiconductor devices, a cured film, a protective film, an insulating film, and a semiconductor devices and a display device using these films can be provided.

### BEST MODE FOR CARRYING OUT THE INVENTION

A photosensitive resin composition, a cured film, a protective film, and an insulating film of the present invention, and a semiconductor device and a display device using the cured film are described below.

The photosensitive resin composition of the present invention comprises an alkali-soluble resin (I) having a polybenzoxazol precursor structure or a polyimide precursor structure, or both, and a photosensitizer (II), the alkali-soluble resin having a ratio ([A]/[B]) of a cyclization rate [A] (%) at 250°C to a cyclization rate [B] (%) at 300°C of 0.70 or more. In the photosensitive resin composition of the present invention, the alkali-soluble resin preferably has a cyclization rate at 250°C of 70% or more.

A protective film and an insulating film of the present invention include a cured film which is a cured product of the photosensitive resin composition.

A semiconductor device and a display device include the cured film.

Each component of the photosensitive resin composition of the present invention will be described in detail below. The following embodiments are shown as examples and are not intended to limit the present invention.

The alkali-soluble resin (I) used in the present invention is a resin having a polybenzoxazole precursor structure or a polyimide resin precursor, or both.

The alkali-soluble resin (I) has the following benzoxazole precursor structure: 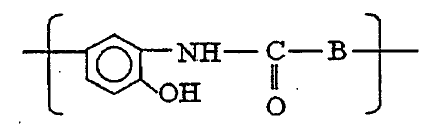 or the following imide precursor structure: 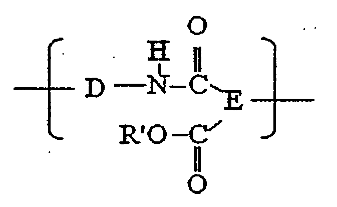 wherein R' is a hydrogen atom, an alkyl group, an alkoxyalkyl group, a trialkylsilyl group, a trihalomethyl group, a phenyl group, a benzyl group, a cycloalkyl group, a tetrahydrofuranyl group, or a tetrahydro pyranyl group, or both of the benzoxazole precursor structure and the imide precursor structure. The main chain of the resin bonds to the benzoxazole precursor structure or the imide precursor structure or both of the benzoxazole precursor structure and the imide precursor structure.

A part of the rings of the benzoxazole precursor structure or the imide precursor structure in the alkali-soluble resin (I) may be closed and the benzoxazole precursor structure and the imide precursor structure may be present as the following benzoxazole structure: 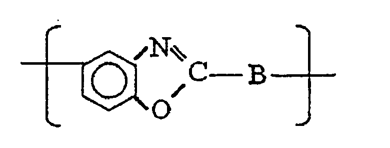 or the following imide structure.

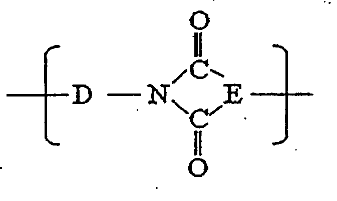

B, D, and E in the above formulas are organic groups.

The alkali-soluble resin (I) have either a phenolic hydroxyl group or a carboxyl group, or both, in the main chain or a side chain, and a part of the phenolic hydroxyl group or the carboxyl group may be etherized or esterified.

In the past, there have been no polyamide resins having at least one of the polybenzoxazole precursor structure and the polyimide resin precursor structure which satisfy the requirement of high productivity when cured at a low temperature. The reason is that when cured at a low temperature, the cyclization reaction does not sufficiently proceed, leaving the alkali-soluble phenolic hydroxyl group or carboxyl group in the resin, which leads to poor moisture resistance and poor chemical resistance due to an increase in the moisture absorption rate and also increases the dielectric constant.

As a result of extensive studies, the inventors of the present invention have found that a photosensitive resin composition comprising an alkali-soluble resin (I) satisfying the relationship between the cyclization rate [A] (%) at 250°C and the cyclization rate [B] (%) at 300°C of [B]≤(10/7)×[A], and preferably [B]≤(4/3)×[A]+(8/3), exhibits high productivity when cured at a wide range of temperatures.

As the curing temperature for measuring the cyclization rate, 250°C which is a temperature generally employed when curing at a low temperature and 300°C which is the lowest temperature in the commonly employed curing temperature at which the cured film performance is thought to remain unchanged were used. When the photosensitive resin composition containing a photosensitizer is cured under the conditions satisfying the ratio [A]/[B] of 0.7 or more, that is, when [B]≤(10/7)×[A], and preferably [B]≤(4/3)×[A]+(8/3) is satisfied, the cyclization rate is almost 100% due to the catalytic effect of the photosensitizer even if the temperature is low. A high cyclization rate is achieved at a wide range of temperatures without fluctuation of performance. Therefore, the yield is increased, giving an effect of high productivity of semiconductor devices.

As examples of the method for obtaining the alkali-soluble resin achieving the requirement of the ratio [A]/[B] of 0.7 or more, that is, satisfying the formula [B]≤(10/7)×[A], and preferably [B]≤(4/3)×[A]+(8/3), a method of reducing the weight average molecular weight of the alkali-soluble resin to 10,000 or less, a method of introducing a siloxane bond or an aliphatic hydrocarbon bond into the main chain and the like can be given. Among these, a method of using a bis(aminophenol) described below is preferable.

Specifically, such an alkali-soluble resin (I) has a bis(aminophenol) having a phenolic hydroxyl group at a position adjacent to an amino group and at least one of the polybenzoxazole precursor structure and the polyimide precursor structure which have a structure derived from a carboxylic acid, wherein the bis(aminophenol) has a substituent at a position adjacent to the both amino groups.

The alkali-soluble resin (I) also has at least one of the polybenzoxazole precursor structure and the polyimide precursor structure obtained by the reaction of a diamine component and a carboxylic acid component, in which all or some diamine components are "bis(aminophenol) compounds in which the both of the amino groups have phenolic hydroxyl groups at positions adjacent thereto and substituents at the other adjacent positions". The "bis(aminophenol) compounds in which the both of the amino groups have phenolic hydroxyl groups at positions adjacent thereto and substituents at the other adjacent positions " are hereinafter referred to from time to time as "bis(aminophenol) (C)".

Furthermore, the bis(aminophenol) (C) preferably has a substituent at the other adjacent positions of the both hydroxyl groups.

In the bis(aminophenol) (C) of the present invention, when the position of the hydroxyl group on the aromatic ring in one of the two aminophenol groups is assumed to be the position 1, this aminophenol group has a hydroxyl group on the position 1, an amino group on the position 2 adjacent to the hydroxyl group, and a substituent on the position 3 adjacent to the amino group. Similarly, when the position of the hydroxyl group on the aromatic ring in the other aminophenol group is assumed to be position 1', this aminophenol group has a hydroxyl group on the position 1', an amino group on the position 2' adjacent to the hydroxyl group, and a substituent on the position 3' adjacent to the amino group. Furthermore, the bis(aminophenol) (C) preferably has a substituent at the other adjacent positions of the hydroxyl groups of the position 1 and position 1' opposite to the amino groups.

As a more specific example of the bis(aminophenol) (C), a compound shown by the following formula (1) can be given. In the bis(aminophenol) shown by the following formula (1), since the amide bond in the alkali-soluble resin (I) is pushed forward to the hydroxyl group side due to the steric hindrance with the substituent (R²) on the position (ortho position) adjacent to the amino group, the distance between the carbon atom of the carbonyl group and the oxygen atom of the hydroxyl group is thought to be reduced. For this reason, the nucleophilic attack of the oxygen atom of the hydroxyl group originating from the bis(aminophenol) in the cyclization reaction onto the carbon atom of the carbonyl group in the amide bond easily takes place, whereby the value [A]/[B] easily exceeds 0.7, showing a high cyclization rate in curing in a wide temperature range. Consequently, high productivity of semiconductor devices can be achieved. 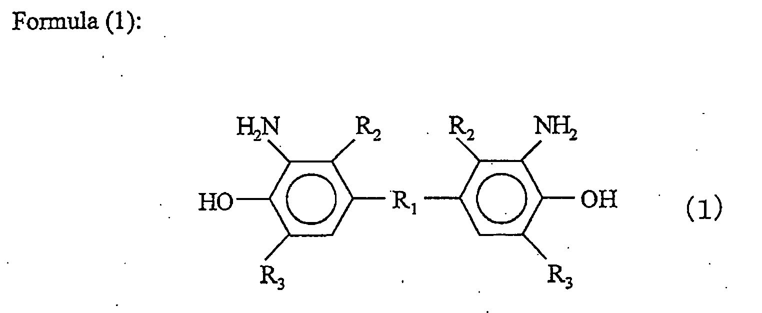 wherein R₁ represents an organic group, R₂ individually represents an alkyl group, an alkoxy group, an acyloxy group, or a cycloalkyl group, and R₃ individually represents a hydrogen atom, an alkyl group, an alkoxy group, an acyloxy group, or a cycloalkyl group.

In the formula (1), R₁ is preferably an alkylene group, a substituted alkylene group, -O-, -S-, -SO₂-, -CO-, -NHCO-, a single bond, or an organic group selected from the groups shown in the following formula (3), 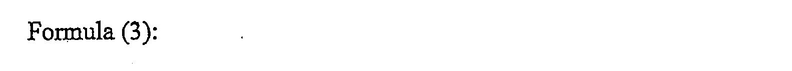 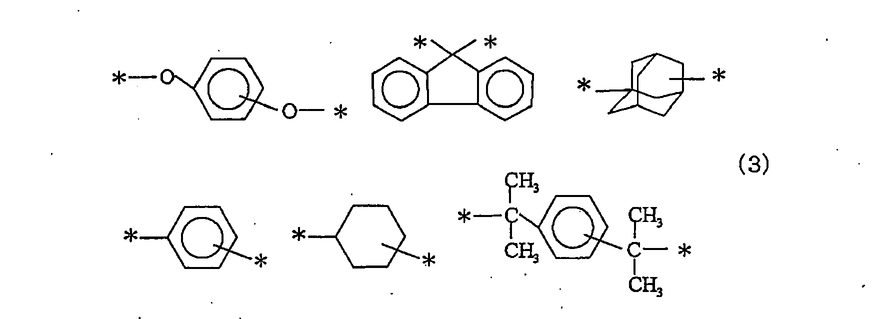 wherein the asterisk (*) indicates one of the aminophenol groups of the above formula (1).

The "single bond" in the definition of R₁ in the above formula (1) indicates that the aromatic rings of the two aminophenol groups bond directly to each other.

The existence of a substituent in the ortho position (R₃) of the phenolic hydroxyl group in the bis(aminophenol) of the above formula (1) is considered to further push forward the phenolic hydroxyl group to the amide bond side due to the steric hindrance with the substituent R₃, causing the phenolic hydroxyl group to come nearer to the amide bond. Thus, the effect of a high cyclization rate is further promoted when cured at a low temperature.

Use of a bis(aminophenol) compound having an alkyl group or an alkoxyl group for R₂ and R₃ in the formula (1) is particularly preferable for obtaining an alkali-soluble resin (I) having well-balanced properties of a high cyclization rate when cured at a low temperature and sufficient solubility in an alkaline aqueous solution. As specific examples of the alkyl group shown by R₂ in the above formula (1), -CH₃, -CH₂CH₃, -CH₂CH₂CH₃, -CH(CH₃)₂, -CH₂CH₂CH₂CH₃, -CH₂CH(CH₃)₂, -CH(CH₃)(CH₂CH₃), -C(CH₃)₃, -CH₂CH₂CH₂CH₂CH₃, -CH₂CH₂CH(CH₃)₂, -CH₂CH(CH₃)(CH₂CH₃), -CH(CH₂CH₃)(CH₂CH₃), -CH(CH₃)(CH₂CH₂CH₃), -CH(CH₃)(CH(CH₃)₂), -CH₂CH₂CH₂CH₂CH₂CH₃, -CH(CH₃)(CH₂CH₂CH₂CH₃), -CH(CH₃)(CH₂CH(CH₃)₂), -CH₂CH₂CH₂CH₂CH₂CH₂CH₃, and -CH₂CH₂CH₂CH₂CH₂CH₂CH₂CH₃ can be given. As specific examples of the alkoxyl group shown by R₂ in the above formula (1), -OCH₃, -OCH₂CH₃, -OCH₂CH₂CH₃, -OCH(CH₃)₂, -OCH₂CH₂CH₂CH₃, -OCH₂CH(CH₃)₂, -OCH(CH₃)(CH₂CH₃), and -OC(CH₃)₃ can be given.

As specific examples of the alkylene group and the substituted alkylene shown by R₁ in the formula (1), -CH₂-, -CH(CH₃)-, -C(CH₃)₂-, -CH(CH₂CH₃)-, -C(CH₃)(CH₂CH₃)-, -C(CH₂CH₃)(CH₂CH₃)-, -CH(CH₂CH₂CH₃)-, -C(CH₃)(CH₂CH₂CH₃)-, -CH(CH(CH₃)₂)-, -C(CH₃)(CH(CH₃)₂)-, -CH(CH₂CH₂CH₂CH₃)-, -C(CH₃)(CH₂CH₂CH₂CH₃)-, -CH(CH₂CH(CH₃)₂)-, -C(CH₃)(CH₂CH(CH₃)₂)-, -CH(CH₂CH₂CH₂CH₂CH₃)-, -C(CH₃)(CH₂CH₂CH₂CH₂CH₃)-, -CH(CH₂CH₂CH₂CH₂CH₂CH₃)-, -C(CH₃)(CH₂CH₂CH₂CH₂CH₂CH₃)-, and the like can be given. Of these, -CH₂-, -CH(CH₃)-, and -C(CH₃)₂- which can produce an alkali-soluble resin (I) exhibiting sufficient solubility not only in an alkaline aqueous solution, but also in a solvent, while achieving a high cyclization rate in a well-balanced manner when cured at a low temperature are preferable.

A part of the diamine component of the alkali-soluble resin (I) may be a diamine other than the bis(aminophenol) which is shown in the above formula (1). Any diamines generally used for preparing a resin having the polybenzoxazole precursor structure or the polyamide precursor structure may be used as the diamine component without particular limitation.

As the carboxylic acid component of the alkali-soluble resin (I), any carboxylic acids generally used as the carboxylic acid component of a resin having the polybenzoxazole precursor structure or the polyimide precursor structure may be used without a particular limitation.

From the viewpoint of promoting heat resistance and reliability after final heating, the alkali-soluble resin (I) is preferably a polyamide resin obtained by the reaction of a diamine component and a carboxylic acid component, wherein the structural units shown by the following formulas (4-1) and (4-2), as the structural unit originating from the diamine component, and the structural unit shown by the following formula (4-3), as the structural unit originating from the carboxylic acid component, are randomly copolymerized by an amide bond (hereinafter referred to from time to time as a "polyamide resin with randomly copolymerized structural units of the formulas (4-1), (4-2), and (4-3)"). Either one structural unit or two or more structural units shown by the following formula (4-1) may be used. Specifically, either a diamine component having the same R₁, the same R₂, and the same R₃ in the structural unit shown by following formula (4-1) or two or more diamine components, each having different R₁, R₂, or R₃ from the other may be used, In addition, when the polyamide resin having randomly copolymerized structural units of the formulas (4-1), (4-2), and (4-3) has a diamine component shown by the following formula (4-2), either one structural unit (4-2) or two or more structural units (4-2) may be used. Specifically, either a diamine component having the same R₄, the same m, and the same X in the structural unit shown by following formula (4-2) or two or more diamine components, each having an R₄, m, or X differing from the other may be used. Similarly, either one structural unit or two or more structural units shown by the following formula (4-3) may be used. Specifically, either a carboxylic acid component having the same R₅, the same n, and the same Y in the structural unit shown by following formula (4-3) or two or more carboxylic acid components, each having an R₅, n, or Y differing from the other may be used. In the following formulas (4-1), (4-2), and (4-3), a and b indicate the number of each structural unit in the resin and do not indicate that each structural unit is continuously linked. The "polyamide resin with randomly copolymerized structural units of the formulas (4-1), (4-2), and (4-3)" includes copolymers having a benzoxazole structure or an imide structure derived by cyclization of a part of the benzoxazole precursor structure or imide precursor structure.

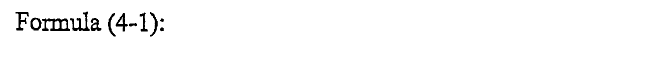

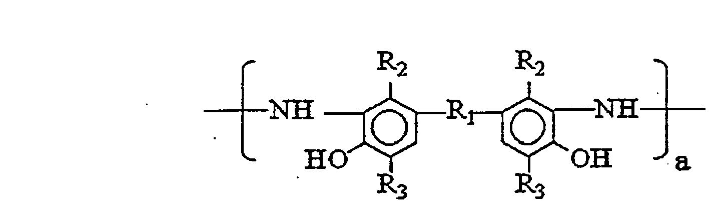

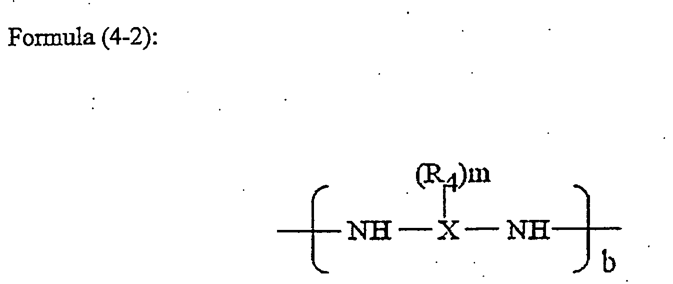

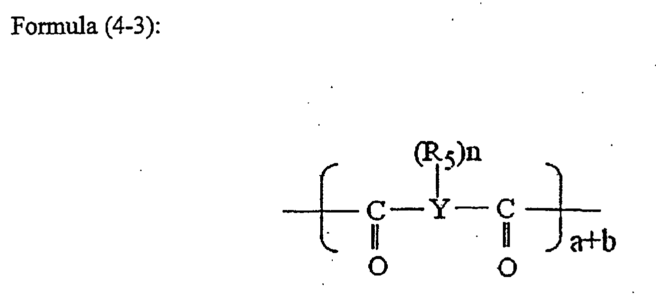

In the formulas (4-1), (4-2), and (4-3), X and Y are organic groups, a and b represent the number of each structural unit in the resin, a is an integer of 1 or more and b is 0 or an integer of 1 or more. In the polyamide resin in which the structural units shown by the formulas (4-1), (4-2), and (4-3) are randomly copolymerized, the mol percent of (4-1) in the diamine component, specifically, {a/(a+b)}×100 (%) is 60 to 100, and the mol percent of (4-2) in the diamine component, specifically, {b/(a+b)}×100 (%), is 0 to 40. In the above formulas, R₁, R₂, and R₃ are the same as the R₁, R₂, and R₃ in the above formula (1), R₄ represents a hydroxyl group or -O-R₇, two or more R₄s may be either the same or different, R₅ represents a hydroxyl group, a carboxyl group, -O-R₇, or -COO-R₇, two or more R₇s may be either the same or different, m is an integer of 0 to 2, n is an integer of 0 to 4, and R₇ represents an organic group having 1 to 15 carbon atoms. In the "polyamide resin with randomly copolymerized structural units of the formulas (4-1), (4-2), and (4-3)", when m in the formula (4-2) is 0 or when all R₄s in the formula (4-2) are not hydroxyl groups, at least one of the R₅s in the formula (4-3) must be a carboxyl, group. When none of the R₅s in the formula (4-3) is a carboxyl group, the content of the diamine component in which at least one of the R₄s in the structural unit (4-2) is a hydroxyl group must be 20 to 40 mol% of the total diamine component.

A film obtained by coating the alkali-soluble resin (I) and drying the coating preferably has a transmittance of light at a wavelength of 365 nm of 40% or more per 5 µm of the film thickness. If the film has a high transmittance, a large amount of actinic rays reach deep in the film, resulting in high sensitivity. High sensitivity ensures an increase in productivity by reducing the exposure time. A more preferable transmittance is 50% or more.

An alkali-soluble resin (I) which can produce a film with a high transmittance of light having a wavelength of 365 nm which is commonly used as a light source for forming a relief pattern can be obtained by using the bis(aminophenol) shown by the above formula (1). This is thought to be due to the structure of the above formula (1) in which it is difficult for the molecule to take a planar structure because of folding of the aromatic rings via R₁ due to the steric hindrance among the substituents shown by R₂ of the formula (1), making it difficult for electric charges to transfer.

An alkali-soluble resin (I) with a ratio of [A]/[B] of 0.70 or more and achieving a cyclization rate of 70% or more when cured at a low temperature of 250°C can be obtained when the mol percent of (4-1) in the diamine component, specifically, {a/(a+b)}×100 (%), is 60 to 100 in the polyamide resin in which the structural units shown by the formulas (4-1), (4-2), and (4-3) are randomly copolymerized. In addition, since a film obtained by coating the alkali-soluble resin (I) and drying the coating has a transmittance of light at a wavelength of 365 nm of 40% or more per 5 µm of the film thickness, both reliability and processability can be satisfied at the same time, providing an effect of high semiconductor device productivity.

The "polyamide resin with randomly copolymerized structural units of the formulas (4-1), (4-2), and (4-3)" is obtained, for example, by reacting a bis(aminophenol) shown by the above formula (1) and, as required, a diamine, bis(aminophenol), 2,4-diaminophenol, or the like including X, and tetracarboxylic acid dianhydride, trimellitic acid anhydride, dicarboxylic acid; dicarboxylic acid dichloride, a dicarboxylic acid derivative, hydroxydicarboxylic acid, or a hydroxydicarboxylic acid derivative including Y In the case of the dicarboxylic acid, an activated ester-type dicarboxylic acid derivative previously reacted with 1-hydroxy-1,2,3-benzotriazole or the like may be used in order to increase the reaction yield.

In the "polyamide resin with randomly copolymerized structural units of the formulas (4-1), (4-2), and (4-3)", -O-R₇ as the substituent of X, and -O-R₇ and -COO-R₇ as the substituent ofY are groups in which the hydroxyl group or the carboxyl group is protected by R₇ which is an organic group having 1 to 15 carbon atoms so as to adjust the solubility of the hydroxyl group or the carboxyl group in an alkaline aqueous solution. The hydroxyl group or the carboxyl group may be protected, as required. As examples of R₇, a formyl group, a methyl group, an ethyl group, a propyl group, an isopropyl group, a tert-butyl group, a tert-butoxycarbonyl group, a phenyl group, a benzyl group, a tetrahydrofuranyl group, a tetrahydropyranyl group, and the like can be given.

The "polyamide resin with randomly copolymerized structural units of the formulas (4-1), (4-2), and (4-3)" is cyclized by dehydration if heated at a high temperature of between 280°C and 380°C or a low temperature of between 150°C and 280°C to produce a heat resistant resin such as a polybenzoxazole resin or a copolymer of a polybenzoxazole resin and a polyimide resin. When processed by heating at a low temperature, the productivity is promoted even in the case in which semiconductor elements with low heat resistance are produced.

X in the above formulas (4-1), (4-2), (4-3) of the "polyamide resin with randomly copolymerized structural units of the formulas (4-1), (4-2), and (4-3)" is an organic group. As examples, aromatic compounds such as a benzene ring and a naphthalene ring, a bisphenol compound, a heterocyclic compound such as a pyrrole compound and a furan compound, a siloxane compound, and the like can be given. More specific examples of such a structure include the structures shown by the following formulas (5-1) to (5-7). These compounds may be used either individually or in combination of two or more inasmuch as the high cyclization rate when cured at a low temperature is not adversely affected. 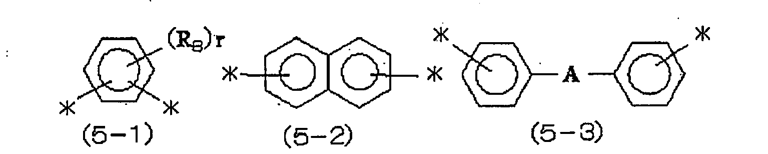 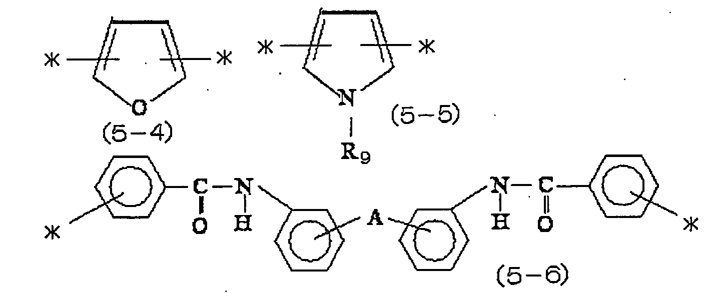 wherein the asterisk (*) indicates a -NH group, A indicates -CH₂-, -C(CH₃)₂-, -O-, -S-, -SO₂-, -CO-, -NHCO-, -C(CF₃)₂-, or a single bond, R₈ is an alkyl group, an alkyl ester group, or a halogen atom, and if there are two or more R₈s, the R₈s may be either the same or different, R₉ represents a hydrogen atom; an alkyl group, an alkyl ester group, or a halogen atom, and r represents an integer from 0 to 2. 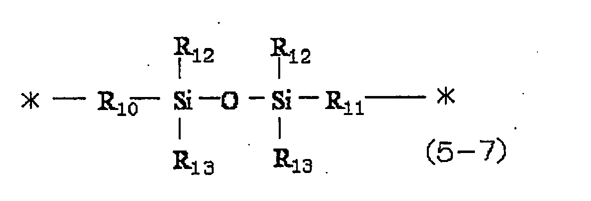 wherein the asterisk (*) indicates a -NH group and R₁₀ to R₁₃ indicate organic groups.

In the "polyamide resin with randomly copolymerized structural units of the formulas (4-1), (4-2), and (4-3)" 0 to 2 R₄s bond to X. In the above formulas (5-1) to (5-7), R₄ is omitted.

In the "polyamide resin with randomly copolymerized structural units of the formulas (4-1), (4-2), and (4-3)", Y in the formulas (4-1), (4-2), and (4-3) is an organic group, and the same groups previously given as examples of X, for example, an aromatic compound such as a benzene ring and a naphthalene ring, a bisphenol compound, a heterocyclic compound such as a pyrrole compound, a pyridine compound, and a furan compound, and a siloxane compound can be given as examples. More specific examples of such a structure include the structures shown by the following formulas (6-1) to (6-8). These compounds may be used either individually or in combination of two or more. 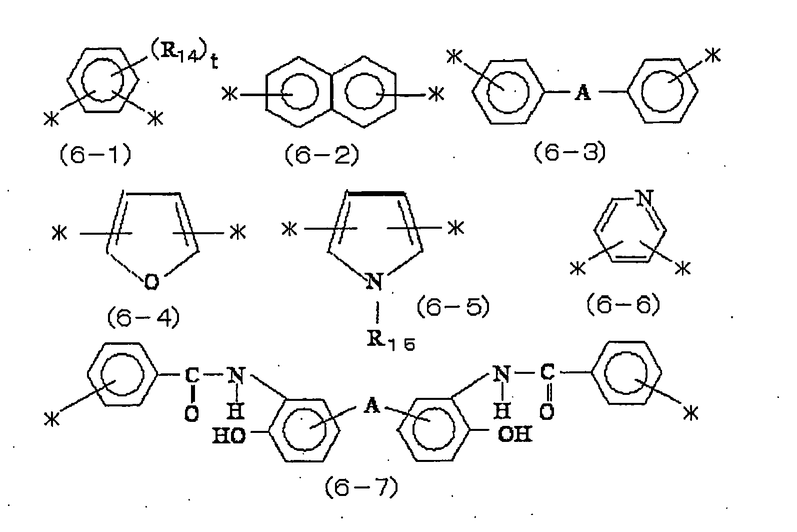 wherein the asterisk (*) indicates C=O, A indicates -CH₂-, -C(CH₃)₂-, -O-, -S-, -SO₂-, -CO-, -NHCO-, -C(CF₃)₂-, or a single bond, R₁₄ is an alkyl group, an alkyl ester group, an alkyl ether group, a benzyl ether group, or a halogen atom, and if there are two or more R₁₄s, the R₁₄s may be either the same or different, R₁₅ represents a hydrogen atom, an alkyl group, an alkyl ester group, or a halogen atom, and t represents an integer from 0 to 2. 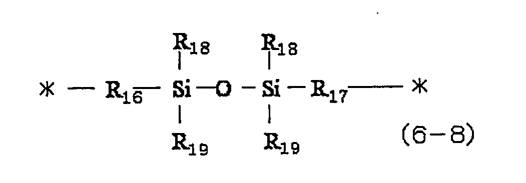 wherein the asterisk (*) indicates C=O and R₁₆ to R₁₉ indicate organic groups.

In the "polyamide resin with randomly copolymerized structural units of the formulas (4-1), (4-2), and (4-3)" 0 to 4 R₅s bond to Y In the above formulas (6-1) to (6-8), R₅ is omitted.

In the "polyamide resin with randomly copolymerized structural units of the formulas (4-1), (4-2), and (4-3)" the amount of the repeating unit including X may be 0 mol%. That is, b may be 0.

In order to achieve high productivity, the glass transition temperature (Tg) of the cured film of the photosensitive resin composition processed at 250°C or a higher temperature is preferably 250°C or higher.

This is to respond to a desire for a resin composition which can be cured at a broad range of temperatures without causing fluctuation in properties of the cured product such as heat cycle resistance, properties and heat shock resistance properties. For this reason, the Tg of the cured product is preferably not lower than the reflow temperature of a lead-free solder. In particular, a cured film obtained by processing at a low temperature of 250°C is desired to have a Tg of not lower than 250°C. For this reason, X and Y in the "polyamide resin with randomly copolymerized structural units of the formulas (4-1), (4-2), and (4-3)" are preferably cyclic compounds, and particularly preferably aromatic compounds. When either X or Y is not a cyclic compound, the amount of the repeating unit containing X or Y is preferably less than 20 mol%.

The amino group at the end of the "polyamide resin with randomly copolymerized structural units of the formulas (4-1), (4-2), and (4-3)" is preferably capped by an amide group using an acid anhydride containing an aliphatic group or a cyclic compound group having at least one alkenyl group or alkynyl group. The storage stability may be improved in this manner. As examples of the group originating from such an acid anhydride having an aliphatic group or a cyclic compound group which includes at least one alkenyl group or alkynyl group, the groups shown in the following formula (7) or formula (8) can be given. These groups may be used either individually or in combination of two or more.

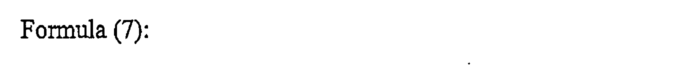

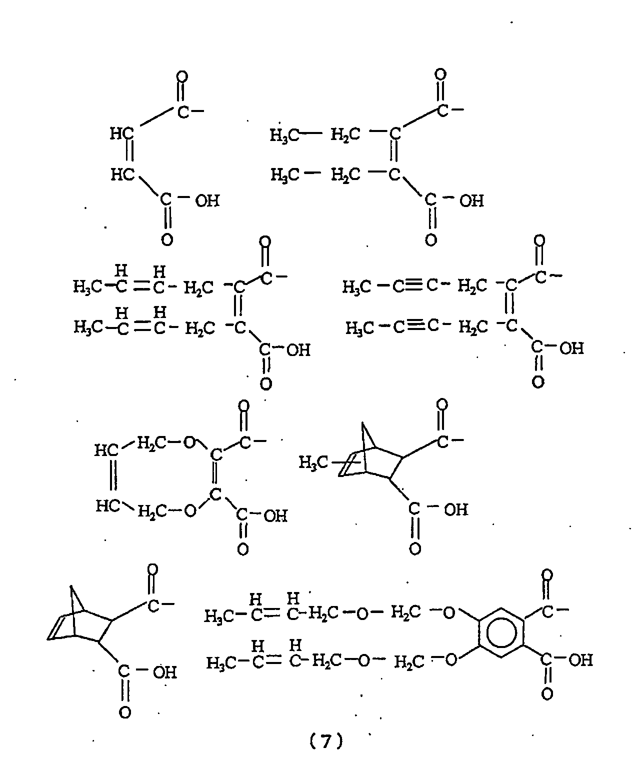

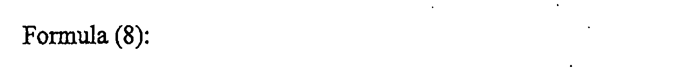

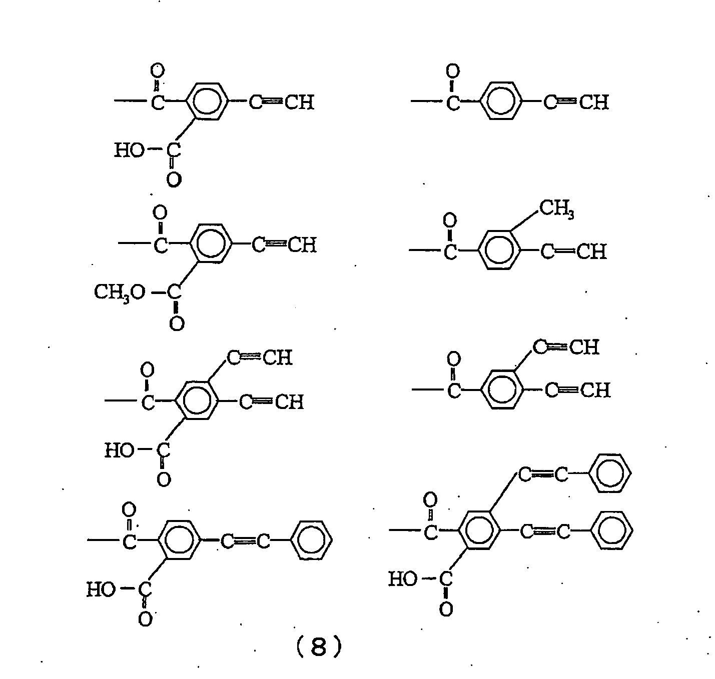

Among these groups, the groups shown by the following formula (9) are particularly preferable. The storage stability may be particularly improved by using these groups.

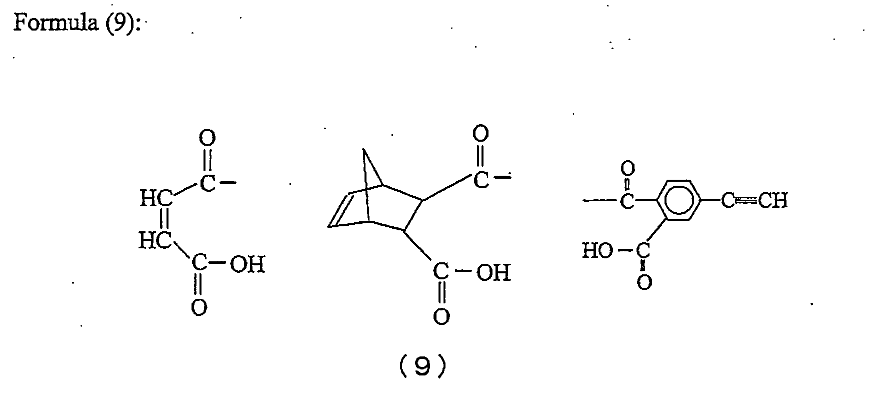

Without being limited to this method, an acid at the terminal of the polyamide resin of the present invention may be capped as an amide using an amine derivative having an aliphatic group or a cyclic compound group which contains at least one alkenyl group or alkynyl group.

A sensitizer capable of forming a positive-type pattern can be used as the photosensitizer (II) in the present invention. Specifically, compounds generating an acid by being irradiated with light such as a photosensitive diazoquinone compound and an onium salt, and dihydropyridine compounds can be used. As examples of the photosensitive diazoquinone compound used as the photosensitizer (II), esters of a phenolic compound and 1,2-naphthoquinone-2-diazido-5-sulfonic acid or 1,2-naphthoquinone-2-diazido-4-sulfonic acid can be given. As specific examples, ester compounds shown by the following formulas (10) to (13) can be given. These compounds may be used either individually or in combination of two or more.

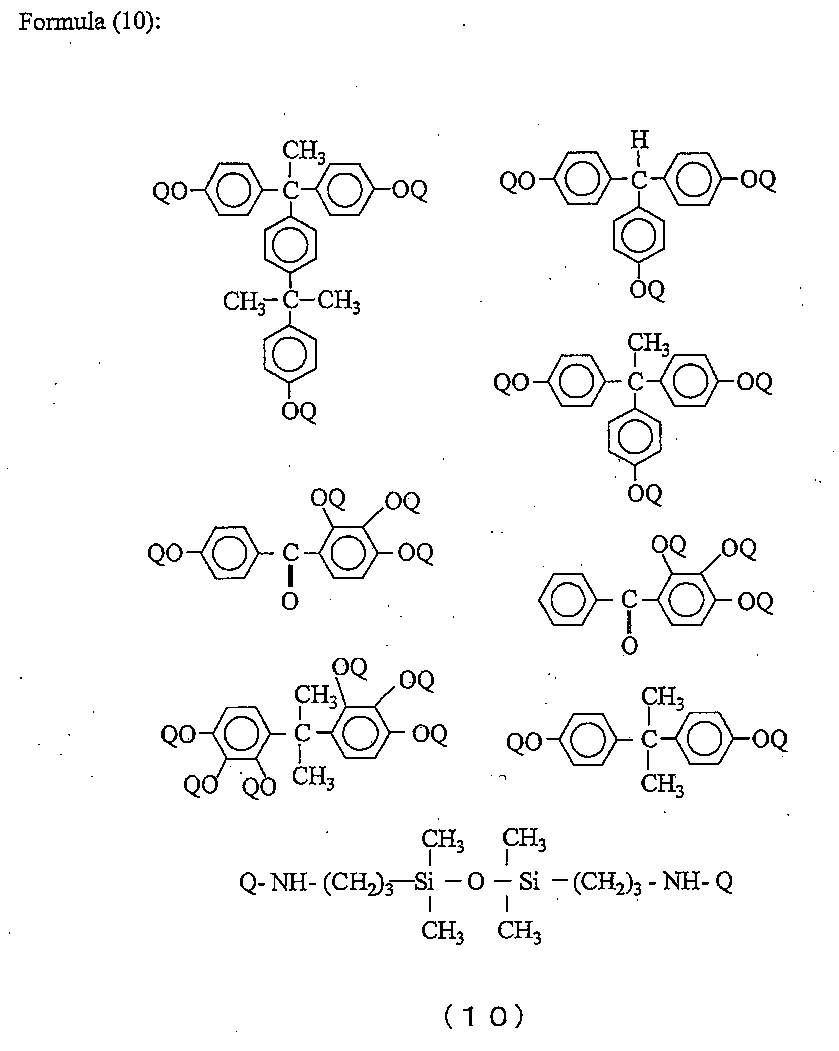

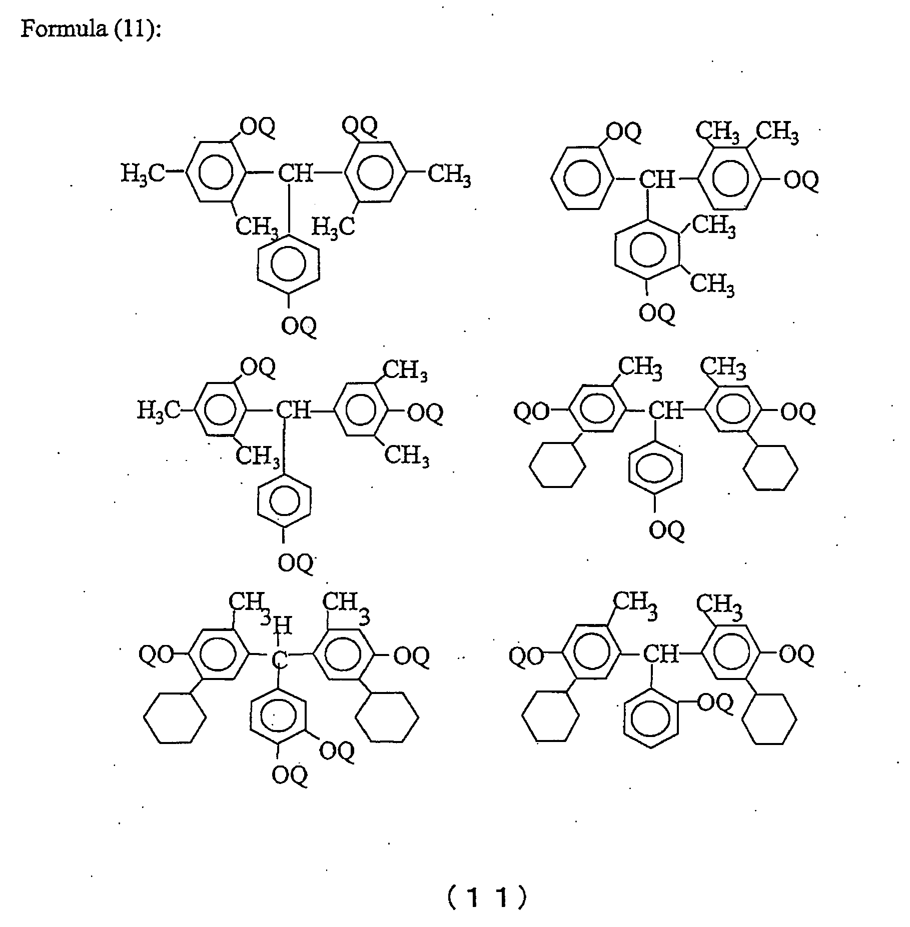

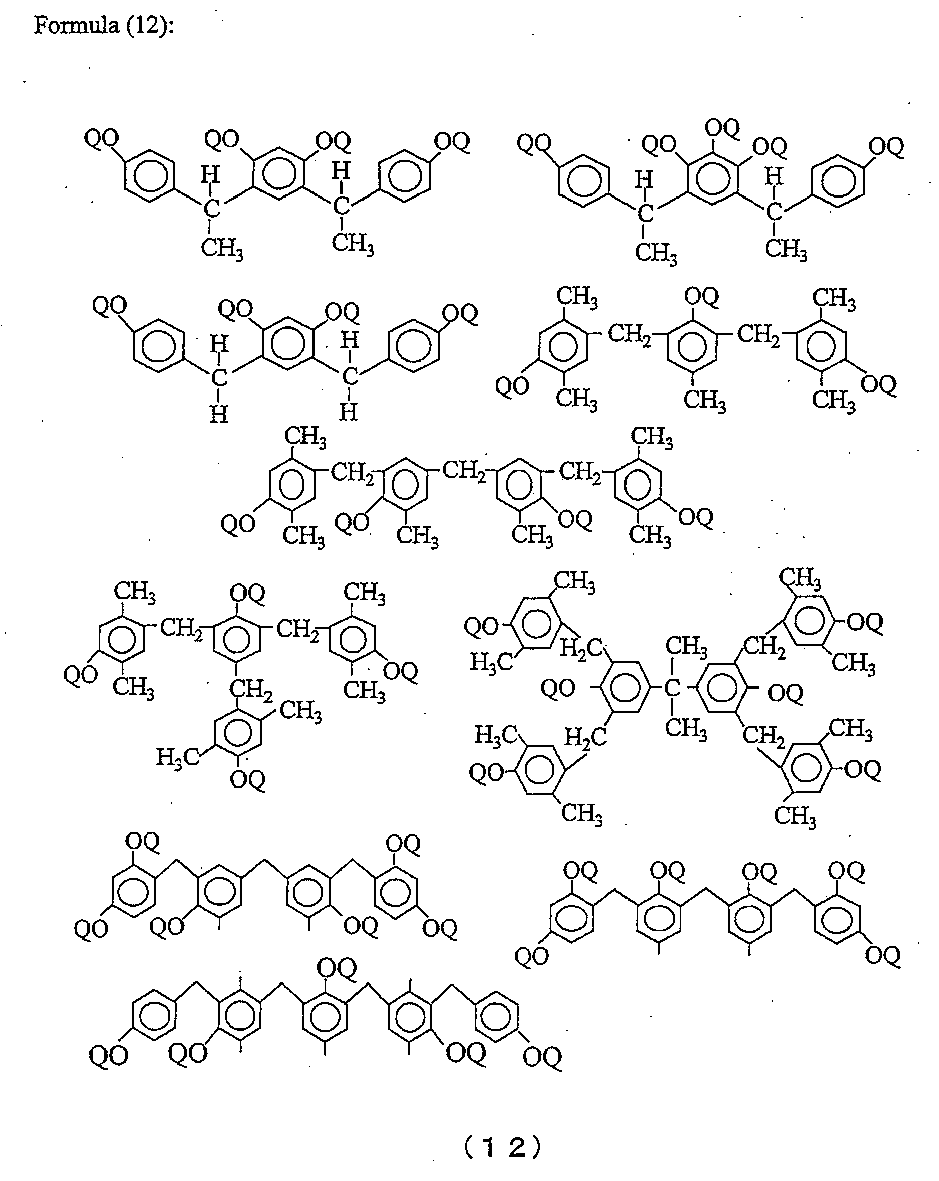

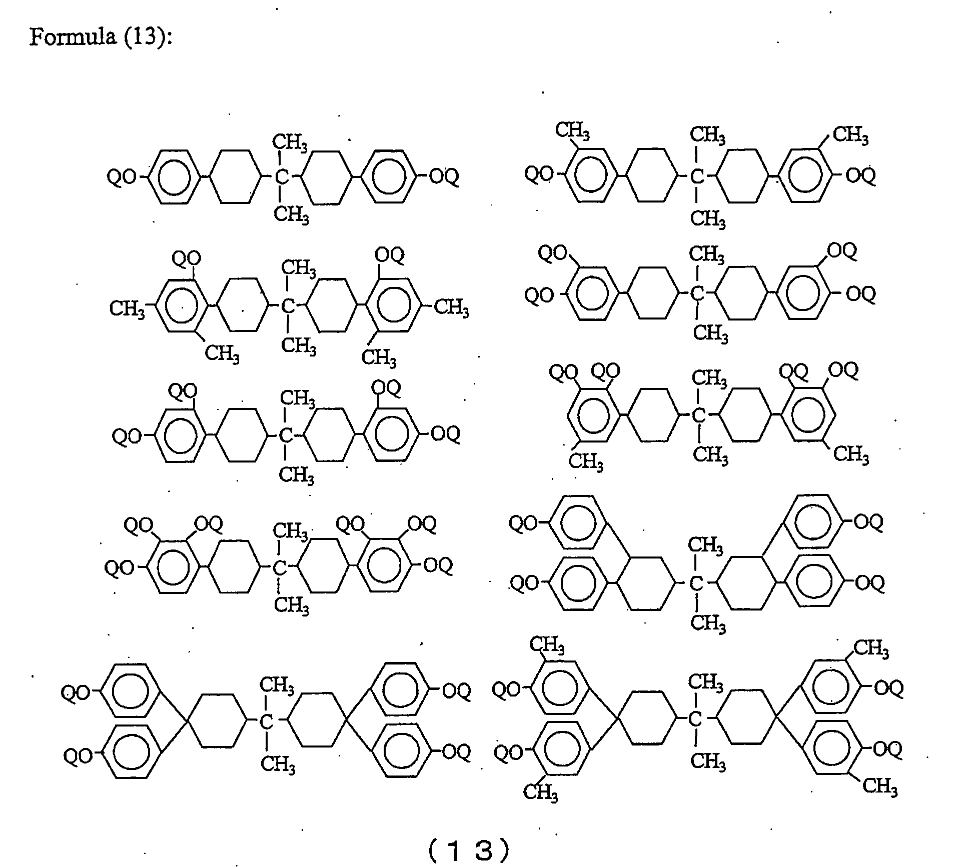

In the formulas (10) to (13), Q is selected from a hydrogen atom, the group shown by the following formula (14), and the group shown by the following formula (15). At least one of the Qs in these compounds shown in the above formulas (10) to (13) is the group shown by the formula (14) or the group shown by the formula (15).

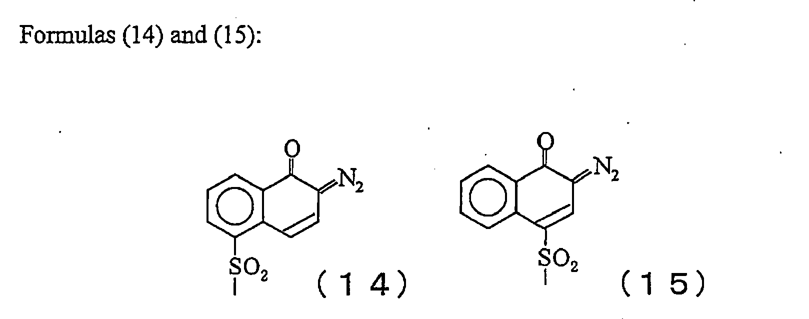

Furthermore, the photosensitive resin composition of the present invention may contain a phenol compound to ensure high sensitivity and excellent patterning without producing a resinous residue (scum).

The resin composition and the photosensitive resin composition of the present invention may further contain additives such a leveling agent, a silane coupling agent, and the like, as required.

In addition to the alkali-soluble resin (I), the photosensitive resin composition of the present invention may contain other alkali-soluble resins in an amount of 0 to 30 parts by mass per 100 parts by mass of the alkali-soluble resin (I). Examples of the other alkali-soluble resin include a cresol novolac resin, a hydroxystyrene resin, an acrylic resin such as a methacrylic acid resin and a methacrylate resin, and a cycloolefin resin containing a hydroxyl group, a carboxyl group, or the like.

These components are dissolved in a solvent and used in the form of a vanish. As examples of the solvent, N-methyl-2-pyrrolidone, γ-butyrolactone, N,N-dimethylacetamide, dimethyl sulfoxide, diethylene glycol dimethyl ether, diethylene glycol diethyl ether, diethylene glycol dibutyl ether, propylene glycol monomethyl ether, dipropylene glycol monomethyl ether, propylene glycol monomethyl ether acetate, methyl lactate, ethyl lactate, butyl lactate, methyl-1,3-butylene glycol acetate, 1,3-butylene glycol 3-monomethyl ether, methyl pyruvate, ethyl pyruvate, methyl 3-methoxypropionate, and the like can be given. These solvents may be used either individually or in combination of two or more.

When using the photosensitive resin composition of the present invention, the photosensitive resin composition is first applied to an appropriate carrier such as a silicon wafer, a ceramic substrate, or an aluminum substrate. When applied to a semiconductor element, the composition is used in an amount to make a film with an ultimate thickness of 1.0 to 30 µm after curing. If the thickness is less than the lower limit, it may be difficult for the film to fully exhibit the function as a surface protective film and an insulating film in semiconductor elements. If more than the upper limit, not only is it difficult to obtain a detailed relief pattern, but also processing will take a long time, resulting in a low throughput. As the method of application, spin coating using a spinner, spray coating using a spray coater, immersion, printing, roll coating, and the like can be given. The coated film is then prebaked at 60 to 130°C (drying), dried, and irradiated with actinic rays to form a desired pattern. As actinic rays, X rays, electron beams, ultraviolet radiation, visible radiation, and the like having a wavelength of 200 to 500 nm may be preferably used.

Next, the irradiated part is dissolved and removed using a developer to obtain a relief pattern. As examples of the developer, an aqueous solution of alkali compounds such as inorganic alkali compounds such as sodium hydroxide, potassium hydroxide, sodium carbonate, sodium silicate, sodium metasilicate, and ammonia water; primary amines such as ethylamine and n-propylamine; secondary amines such as diethylamine and di-n-propylamine; tertiary amines such as triethylamine and methyldiethylamine; alcohol amines such as dimethylethanolamine and triethanolamine; quaternary ammonium salts such as tetramethylammonium hydroxide and tetraethylammonium hydroxide; an aqueous solution obtained by adding an appropriate amount of a water-soluble organic solvent such as an alcohol (such as methanol and ethanol) or a surfactant may be given. As the development method, spraying, paddling, dipping, application of supersonic waves, and the like may be used.

Next, the relief pattern formed by development is rinsed. Distilled water is used as a rinse. The resulting product is then treated with heat (cured) to form an oxazole ring or an oxazole ring and an imide ring, whereby a cured product having excellent heat resistance can be obtained.

Either heat treatment at a high temperature or a low temperature is possible. A high temperature treatment is preferably carried out at 280 to 380°C, and more preferably 290 to 350°C. A low temperature treatment is carried out preferably at 150 to 280°C, and more preferably 180 to 260°C.

Next, the cured film of the photosensitive resin composition will be described. The cured film which is a cured product of the photosensitive resin composition is useful not only for semiconductor devices such as a semiconductor element, but also for display devices such as a TFT liquid crystal display device and an organic EL display device, an interlayer dielectric of a multilayered circuit, a cover coat of a flexible copper-clad board, a solder resist film, and a liquid crystal alignment film.

As examples of the application to semiconductor devices, a passivation film obtained by forming a cured film of the photosensitive resin composition on a semiconductor element, a protective film such as a buffer coat film obtained by forming a cured film of the photosensitive resin composition on the passivation film, an insulating film such as an interlayer dielectric obtained by forming a cured film of the photosensitive resin composition on a circuit formed on a semiconductor element, an α-ray shielding film, a planarizing film, a projection (resin post), a barrier rib, and the like can be given.

As examples of the application to the display device, a protective film obtained by forming a cured film of the photosensitive resin composition on a display element, an insulating film or a planarized film for a TFT element or a color filter, a projection for an MVA-type liquid crystal display device and the like, a barrier rib for organic EL element cathodes and the like can be given. The method of use of the composition for semiconductor devices applies to the method of use for the display devices, that is, a method of forming a patterned layer of the photosensitive resin composition on a substrate on which a display element or a color filter is formed may be used. High transparency is required particularly for an insulating film or a flattening film of display devices. A resin layer with such excellent transparency can be obtained by introducing a post exposure process before curing the layer of the photosensitive resin composition. Introduction of such a post exposure process is more preferable in practice.

### EXAMPLES

The present invention will be specifically described by Examples and Comparative Examples which are not intended to be limiting of the present invention.

### <Example 1>

### Synthesis of alkali-soluble resin

A four-neck separable flask equipped with a thermometer, a stirrer, a raw material inlet port, and a dry nitrogen gas feed pipe was charged with 408.97 g (0.880 mol) of a dicarboxylic acid derivative (active ester), which was obtained by reacting 0.264 mol of isophthalic acid, 0.616 mol of diphenyl ether-4,4'-dicarboxylic acid, and 1.760 mol of 1-hydroxy-1,2,3-benzotriazole, and 286.37 g (1.000 mol) of 4,4'-methylenebis(2-amino-3,6-dirnethylphenol). 2780 g of N-methyl-2-pyrrolidone was added to dissolve the mixture. The mixture was reacted at 75°C for 16 hours using an oil bath. Next, 41.31 g (0.240 mol) of 4-ethynylphthalic anhydride dissolved in 160 g of N-methyl-2-pyrrolidone was added and the mixture was stirred for further three hours to complete the reaction. The reaction mixture was filtered and poured into a 3:1 (volume ratio) mixture of water and methanol. The resulting precipitate collected by filtration was sufficiently washed with water and dried under vacuum to obtain an alkali-soluble resin (A-1) ("polyamide resin with randomly copolymerized structural units of the formulas (4-1), (4-2), and (4-3)") having a cyclization rate satisfying the equations {a/(a+b)}×100=100 and {b/(a+b)}×100=0. The alkali-soluble resin (A-1) had a number average molecular weight of 10,500 and consisted of the compounds shown in Table 1.

### Evaluation of transmittance

A solution prepared by dissolving 4.0 g of the alkali-soluble resin (A-1) in 8.0 g of γ-butyrolactone was applied to a quartz board using a spin coater and dried on a hot plate at 120°C for four minutes to obtain a coated film with a thickness of 5 µms. The transmittance of this coated film was measured with an ultraviolet/visible region spectrophotometer (manufactured by Shimadzu Corp). The transmittance at a wavelength of 365 nm was 65%.

### Evaluation of cyclization rate (alkali-soluble resin)

The above alkali-soluble resin was applied to three sheets of silicon wafers using a spin coater and prebaked on a hot plate at 120°C for three minutes to obtain coated films, each having a thickness of about 1 µm. Next, one sheet of the silicon wafer with a coated film thereon was immersed in 2% hydrofluoric acid aqueous solution to obtain a cured film. The film was analyzed using a Fourier transform infrared spectrophotometer, PARAGON1000 (product manufactured by Perkin Elmer) to determine the ratio (a) of the peak of the amide group at 1650 cm⁻¹ to the peak of the total aromatic group at 1490 cm⁻¹. Next, the other silicon wafer with a coated film was heated in an oven at 250°C for 90 minutes to obtain a cured film in the same manner. The film was analyzed using a Fourier transform infrared spectrophotometer to calculate the ratio (b) of the peak of the amide group at 1650 cm⁻¹ to the peak of the total aromatic group at 1490 cm⁻¹. The third silicon wafer with a coated film was heated in an oven at 300°C for 90 minutes to obtain a cured film in the same manner. The film was analyzed using a Fourier transform infrared spectrophotometer to calculate the ratio (c) of the peak of the amide group at 1650 cm⁻¹ to the peak of the total aromatic group at 1490 cm⁻¹.

The cyclization rate [A] at 250°C was calculated by multiplying (1-{(b)/(a)}) by 100. The cyclization rate thus calculated was 82%. The cyclization rate [B] at 300°C was calculated by multiplying (1-{(c)/(a)}) by 100. The cyclization rate thus calculated was 100%. The ratio [A]/[B] was 0.82, indicating that the obtained alkali-soluble resin has only a small fluctuation in the cyclization rate in a broad range of temperatures.

### Synthesis of photosensitizer

A four-neck separable flask equipped with a thermometer, a stirrer, a raw material inlet port, and a dry nitrogen gas feed pipe was charged with 13.53 g (0.0214 mol) of a phenol compound shown by the following formula (B-1) and 7.62 g (0.0753 mol) of triethylamine. 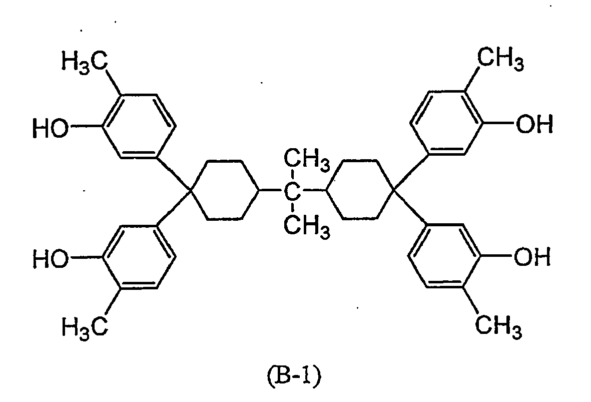 108.65 g of tetrahydrofuran was added to dissolve the mixture. After cooling the reaction mixture to 10°C or less, 20.22 g (0.0753 mol) of 1,2-naphthoquinone-2-diazido-4-sulfonylchloride was slowly added dropwise together with 100 g of tetrahydrofuran while maintaining the temperature at less than 10°C. After stirring for five minutes at 10°C or less, the reaction mixture was stirred at room temperature for five hours before terminating the reaction. After filtering, the reaction mixture was poured into a 3:1 (volume ratio) mixture of water and methanol. The resulting precipitate was collected, sufficiently washed with water, and dried under vacuum to obtain a photosensitizer shown by the following formula (Q-1). 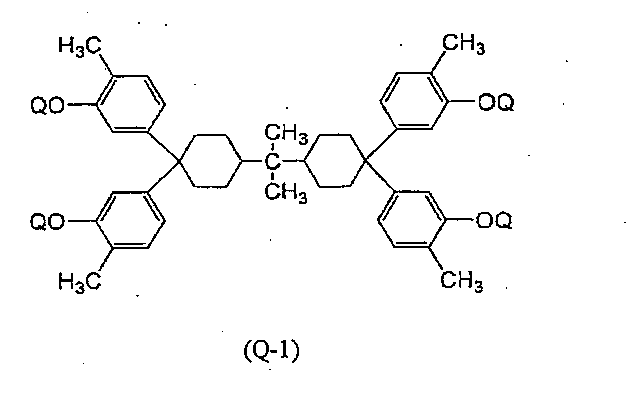 wherein Q represents a hydrogen atom or a group shown by the following formula (Q-1-i) of which the percentage by weight of Q is 88%, with the balance being a hydrogen atom.

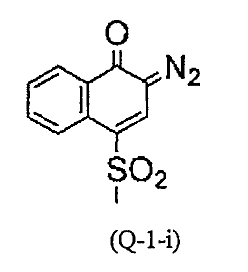

### Preparation of photosensitive resin composition

100 g of the synthesized alkali-soluble resin (A-1) and 13.5 g of a photosensitizer which has a structure of the formula (Q-1) were dissolved in a mixed solvent of 100 g of N-methyl-2-pyrrolidone and 100 g of y-butyrolactone. The solution was filtered through a Teflon (registered trademark) filter with a pore size of 0.2 µms to obtain a photosensitive resin composition.

### Evaluation of sensitivity

The photosensitive resin composition was applied to a silicon wafer using a spin coater and prebaked on a hot plate at 120°C for three minutes to obtain a coated film with a thickness of about 8.0 µm. The coated film was irradiated using an i-line stepper (4425i manufactured by Nikon Corp.) through a mask (a test chart No. 1 having a remnant pattern and an extract pattern, each having a width of 0.88 to 50 µms, manufactured by Toppan Printing Co., Ltd.) while changing the exposure dose.

Then, the resist was developed twice by a paddle method using an aqueous solution of 2.38% tetramethylammonium hydroxide for 120 seconds each time to remove the exposed areas and washed with purified water for 10 seconds. As a result, it was confirmed that the pattern was formed starting at the area irradiated at a dose of 230 mJ/cm², indicating vary high sensitivity (sensitivity was 230 mJ/cm²). The film thickness after development was 7.9 µms, which was a very large thickness.

### Evaluation of cyclization rate (photosensitive resin composition)

The above photosensitive resin composition was applied to three sheets of silicon wafers using a spin coater and prebaked on a hot plate at 120°C for three minutes to obtain coated films, each having a thickness of about 1 µm. Next, one sheet of the silicon wafer with a coated film thereon was immersed in 2% hydrofluoric acid aqueous solution to obtain a cured film. The film was analyzed using a Fourier transform infrared spectrophotometer, PARAGON1000 (a product manufactured by Perkin Elmer) to determine the ratio (d) of the peak of amide group at 1650 cm⁻¹ to the peak of the total aromatic group at 1490 cm⁻¹.

Next, the other silicon wafer with a coated film was heated in an oven at 250°C for 90 minutes to obtain a cured film in the same manner. The film was analyzed using a Fourier transform infrared spectrophotometer to calculate the ratio (e) of the peak of the amide group at 1650 cm⁻¹ to the peak of the total aromatic group at 1490 cm⁻¹. The remaining silicon wafer with a coated film was heated at 300°C for 90 minutes to calculate the ratio (f) of the peak of the amide group at 1650 cm⁻¹ to the peak of the total aromatic group at 1490 cm⁻¹ in the same manner. The cyclization rate [A] at 250°C was calculated by multiplying (1-{(e)/(d)}) by 100. The cyclization rate thus calculated was 96%. The cyclization rate at 300°C was calculated by multiplying (1-{(f)/(d)}) by 100. The cyclization rate thus calculated was 100%. It was confirmed that the photosensitive resin composition has only a small fluctuation in the cyclization rate in a broad range of temperatures.

### Evaluation of glass transition temperature (Tg)

The above photosensitive resin composition was applied to a 6 inch silicon wafer using a spin coater and prebaked on a hot plate at 120°C for three minutes to obtain a coated film having a thickness of about 10 µms. The silicon wafer with the coated film thereon was heated in an oven at 250°C for 90 minutes. Next, the resulting cured film was immersed in 2% hydrofluoric acid aqueous solution to remove the film from the silicon wafer. The resulting film was sufficiently washed with purified water and dried in an oven. After drying, the film was cut into a sample specimen with a width of 5 mm to measure the glass transition temperature using a thermomechanical analyzer (TMA), SS6000 manufactured by Seiko Instruments, Inc. to find that the glass transition temperature was 265°C.

### Evaluation of water absorption

The above photosensitive resin composition was applied to three sheets of 6 inch silicon wafers using a spin coater and prebaked on a hot plate at 120°C for three minutes to obtain coated films having a thickness of about 10 µms. One sheet of the silicon wafers with the coated film thereon was heated in an oven at 250°C for 90 minutes. Another sheet of silicon wafer with the coated film was heated at 300°C for 90 minutes. The last sheet of silicon wafer with the coated film was heated at 350°C for 90 minutes.

After curing, the coated films were cut into 5 cm×5 cm square and immersed in a 2% hydrofluoric acid aqueous solution. The water absorption of the films was measured according to JIS-K7209. It was found that the water absorption of the cured film treated with heat at 250°C for 90 minutes was 0.7%, the cured film treated with heat at 300°C for 90 minutes was 0.6%, and the cured film treated with heat at 350°C for 90 minutes was 0.5%.

The difference between the maximum water absorption and the minimum water absorption among the cured films treated with heat at 250°C, 300°C, and 350°C was calculated. The result was only 0.2%, which is a very low value.

The difference was less than 0.5%. While the maximum water absorption of 1% is considered to be usable without a problem in practice, the photosensitive resin composition of the present invention was confirmed to have only small water absorption when cured over a broad range of temperatures. In addition, since the fluctuation of the water absorption values was small, the productivity was confirmed to be excellent. This is thought to be the result of disappearance of almost all the phenolic hydroxyl group which is the alkali soluble group in the alkali-soluble resin due to the sufficient progress of the cyclization reaction even in the case in which the resin is cured over a broad range of temperatures.

### <Example 2>

The reaction was carried out in the same manner as in Example 1, except for reducing the amount of 4,4'-methylenebis(2-amino-3,6-dimethylphenol) to 200.46 g (0.700 mol) and using instead 69.08 g (0.300 mol) of 3,3'-diamino-4,4'-dib.ydroxydiphenylinethane to obtain an alkali-soluble resin (A-2) ("polyamide resin with randomly copolymerized structural units of the formulas (4-1), (4-2), and (4-3)") having a cyclization rate satisfying the equations {a/(a+b)}×100=70 and {b/(a+b}}×100=30. The alkali-soluble resin (A-2) had a number average molecular weight of 11,200 and consisted of the compounds shown in Table 1. A photosensitive resin composition was prepared and evaluated in the same manner as in Example 1.

### <Example 3>

The reaction was carried out in the same manner as in Example 1, except for using 77.50 g (0.300 mol) of 2,2-bis(3-amino-4-hydroxyphenyl)propane instead of 3,3'-diamino-4,4'-dihydroxydiphenylmethane to obtain an alkali-soluble resin (A-3) ("polyamide resin with randomly copolymerized structural units of the formulas (4-1), (4-2), and (4-3)") having a cyclization rate satisfying the equations {a/(a+b)}×100=70 and {b/(a+b)}×100=30. The alkali-soluble resin (A-3) had a number average molecular weight 11,800 and consisted of the compounds shown in Table 1. A photosensitive resin composition was prepared and evaluated in the same manner as in Example 1.

### <Example 4>

The reaction was carried out in the same manner as in Example 1, except for reducing the amount of 4,4'-methylenebis(2-amino-3,6-dimethylphenol) to 249.14 g (0.870 mol) and using instead 28.03 g (0.100 mol) of 3,3'-diamino-4,4'-dihydroxydiphenylsulfone and 7.46 g (0.030 mol) of 1,3-bis(3-aminopropyl)tetramethyldisiloxane to obtain an alkali-soluble resin (A-4) ("polyamide resin with randomly copolymerized structural units of the formulas (4-1), (4-2), and (4-3)") having a cyclization rate satisfying the equations {a/{a+b)}×100=87 and {b/{a+b)}×100=13. The alkali-soluble resin (A-4) had a number average molecular weight of 11,000 and consisted of the compounds shown in Table 1. A photosensitive resin composition was prepared and evaluated in the same manner as in Example 1.

### <Example 5>

The reaction was carried out in the same manner as in Example 1, except for increasing the amount of diphenyl ether-4,4'-dicarboxylic acid instead of using isophthalic acid, additionally using 54.60 g (0.176 mol) of 4,4'-oxydiphthalic anhydride, reducing the amount of 4,4'-methylenebis(2-amino-3,6-dimethylphenol) to 143.19 g (0.500 mol), and instead using 183.13 g (0.500 mol) of hexafluoro-2,2-bis(3-amino-4-hydroxyphenyl)propane to obtain an alkali-soluble resin (A-5) ("polyamide resin with randomly copolymerized structural units of the formulas (4-1), (4-2), and (4-3)") having a cyclization rate satisfying the equations {a/(a+b)}×100=50 and {b/(a+b)}×100=50. The alkali-soluble resin (A-5) had a number average molecular weight of 12,100 and consisted of the compounds shown in Table 1. A photosensitive resin composition was prepared and evaluated in the same manner as in Example 1.

### <Example 6>

The reaction was carried out in the same manner as in Example 1, except for changing the amount of isophthalic acid and diphenyl ether-4,4'-dicarboxylic acid respectively to 0.344 mol and 0.516 mol, using 300.40 g (1.000 mol) of 4,4'-ethylidenebis(2-nitro-3,6-dimethylphenol) instead of 4,4'-methylenebis(2-amino-3,6-dimethylphenol) to obtain an alkali-soluble resin (A-6) ("polyamide resin with randomly copolymerized structural units of the formulas (4-1), (4-2), and (4-3)") having a cyclization rate satisfying the equations {a/{a+b)}×100=100 and {b/(a+b)}×100=0. The number average molecular weight of the polyamide resin (A-6) was 10,200 and the resin consisted of the compounds shown in Table 1. A photosensitive resin composition was prepared and evaluated in the same manner as in Example 1, except for changing the amount of the photosensitizer having a structure of the formula (Q-1) to 12.5 g.

### <Example 7>

The reaction was carried out in the same manner as in Example 6, except for changing the amount of isophthalic acid and diphenyl ether-4,4'-dicarboxylic acid respectively to 0.252 mol and 0.588 mol, reducing the amount of 4,4'-ethylenebis(2-amino-3,6-dimethylphenol) to 210.28 g (0.700 mol) and instead using 69.08 g (0.300 mol) of 3,3'-diamino-4,4'-dihydroxydiphenylmethane, and changing the amount of 4-ethynylphthalic anhydride to 55.08 g (0.320 mol) to obtain an alkali-soluble resin (A-7) ("polyamide resin with randomly copolymerized structural units of the formulas (4-1), (4-2), and (4-3)") having a cyclization rate satisfying the equations {a/(a+b)}×100=70 and {b/(a+b)}×100=30. The number average molecular weight of the polyamide resin (A-7) was 9500 and the resin consisted of the compounds shown in Table 1. A photosensitive resin composition was prepared and evaluated in the same manner as in Example 1, except for changing the amount of the photosensitizer having a structure of the formula (Q-1) to 14.0 g.

### <Example 8>

The reaction was carried out in the same manner as in Example 7, except for using 77.50 g (0.300 mol) of 2,2-bis(3-amino-4-hydroxyphenyl)propane instead of 3,3'-diamino-4,4'-dihydroxydiphenylmethane to obtain an alkali-soluble resin (A-8) ("polyamide resin with randomly copolymerized structural units of the formulas (4-1), (4-2), and (4-3)") having a cyclization rate satisfying the equations {a/(a+b)}×100=70 and {b/(a+b)}×100=30. The alkali-soluble resin (A-8) had a number average molecular weight 9600 and consisted of the compounds shown in Table 1. A photosensitive resin composition was prepared and evaluated in the same manner as in Example 1, except for changing the amount of the photosensitizer having a structure of the formula (Q-1) to 14.0 g.

### <Example 9>

The reaction was carried out in the same manner as in Example 6, except for changing the amount of isophthalic acid and diphenyl ether-4,4'-dicarboxylic acid respectively to 0.336 mol and 0.504 mol, using 436.64 g (1.000 mol) of 4,4'-ethylenebis(2-amino-3-methyl-6-cyclohexylphenol) instead of 4,4'-ethylidenebis(2-amino-3,6-dimethylphenol) to obtain an alkali-soluble resin (A-9) ("polyamide resin with randomly copolymerized structural units of the formulas (4-1), (4-2), and (4-3)") having a cyclization rate satisfying the equations (a/(a+b))×100=100 and {b/{a+b)}×100=0. The number average molecular weight of the polyamide resin (A-9) was 8700 and the resin consisted of the compounds shown in Table 1. A photosensitive resin composition was prepared and evaluated in the same manner as in Example 1, except for changing the amount of the photosensitizer having a structure of the formula (Q-1) to 15.0 g.

### <Comparative Example 1>

### Synthesis of alkali-soluble resin

A four-neck separable flask equipped with a thermometer, a stirrer, a raw material inlet port, and a dry nitrogen gas feed pipe was charged with 408.97 g (0.880 mol) of a dicarboxylic acid derivative (active ester), which was obtained by reacting 0.264 mol of isophthalic acid, 0.616 mol of diphenylether-4,4'-dicarboxylic acid, and 1.760 mol of 1-hydroxy-1,2,3-benzotriazole, 256.38 g (0.700 mol) of hexafluoro-2,2-bis(3-amino-4-hydroxyphenyl)propane, and 77.50 g (0.300 mol) of 2,2-bis(3-amino-4-hydroxyphenyl)propane. 2970 g ofN-methyl-2-pyrrolidone was added to dissolve the mixture. The mixture was reacted at 75°C for 16 hours using an oil bath.

Next, 41.31 g (0.240 mol) of 4-ethynylphthalic anhydride dissolved in 160 g of N-methyl-2-pyrrolidone was added and the mixture was stirred for a further three hours to complete the reaction. The reaction mixture was filtered and poured into a 3:1 (volume ratio) mixture of water and isopropanol. The resulting precipitate collected by filtration was sufficiently washed with water and dried under vacuum to obtain an alkali-soluble resin (A-10) ("polyamide resin with randomly copolymerized structural units of the formulas (4-1), (4-2), and (4-3)") having a cyclization rate satisfying the equations {a/(a+b)×100=0 and {b/(a+b)}×100=100. The alkali-soluble resin (A-10) had a number average molecular weight of 11,300 and consisted of the compounds shown in Table 1. A photosensitive resin composition was prepared and evaluated in the same manner as in Example 1.

### <Comparative Example 2>

The reaction was carried out in the same manner as in Example 1, except for using 196.21 g (0.700 mol) of 3,3'-diamino-4,4'-dihydroxydiphenylsulfone and 69.08 g (0.300 mol) of 3,3'-diamino-4,4'-dihydroxydiphenylmethane instead of 4,4'-methylenebis(2-amino-3,6-dimethylphenol) to obtain an alkali-soluble resin (A-11) ("polyamide resin with randomly copolymerized structural units of the formulas (4-1), (4-2), and (4-3)") having a cyclization rate satisfying the equations {a/(a+b)}×100=0 and {b/(a+b)}×100=100. The alkali-soluble resin (A-11) had a number average molecular weight of 11,800 and consisted of the compounds shown in Table 1. A photosensitive resin composition was prepared and evaluated in the same manner as in Example 1.

### <Example 10>

A four-neck separable flask equipped with a thermometer, a stirrer, a raw material inlet port, and a dry nitrogen gas feed pipe was charged with 375.32 g (0.860 mol) of a dicarboxylic acid derivative (active ester), which was obtained by reacting 0.430 mol of adipic acid, 0.430 mol of diphenylether-4,4'-dicarboxylic acid, and 1.720 mol of 1-hydroxy-1,2,3-benzotriazole, 256.38 g (0.700 mol) of hexafluoro-2,2-bis(3-amino-4-hydroxyphenyl)propane, and 69.68 g (0.300 mol) of bis(3-amino-4-hydroxyphenyl)ether. 2970 g of N-methyl-2-pyrrolidone was added to dissolve the mixture. The mixture was reacted at 75°C for 16 hours using an oil bath.

Next, 48.20 g (0.280 mol) of 4-ethynylphthalic anhydride dissolved in 190 g of N-methyl-2-pyrrolidone was added and the mixture was stirred for a further three hours to complete the reaction. The reaction mixture was filtered and poured into a 3:1 (volume ratio) mixture of water and iso-propanol. The resulting precipitate collected by filtration was sufficiently washed with water and dried under vacuum to obtain an alkali-soluble resin (A-12) ("polyamide resin with randomly copolymerized structural units of the formulas (4-1), (4-2), and (4-3)") having a cyclization rate satisfying the equations {a/(a+b)}×100=0 and {b/(a+b)×100=100. The alkali-soluble resin (A-12) had a number average molecular weight of 8600 and consisted of the compounds shown in Table 1.

A photosensitive resin composition was prepared in the same manner as in Example 1, except for changing the amount of the photosensitizer having a structure of the formula (Q-1) to 22 g.

The resulting photosensitive resin composition was evaluated in the same manner as in Example 1, except that in the sensitivity evaluation the developing time by the paddle method was adjusted so that the film thickness difference before and after prebaking was 1 µm.

### <Example 11>

A four-neck separable flask equipped with a thermometer, a stirrer, a raw material inlet port, and a dry nitrogen gas feed pipe was charged with 439.68 g (0.860 mol) of a dicarboxylic acid derivative (active ester), which was obtained by reacting 0.344 mol of 1,3-bis(4-carboxyphenyl)-1,1,3,3-tetramethyldisiloxane, 0.258 mol of isophthalic acid, 0.258 mol of diphenyl ether-4,4'-dicarboxylic acid, and 1.720 mol of 1-hydroxy-1,2,3-benzotriazole and 366.26 g (1.000 mol) of hexafluoro-2,2-bis(3-amino-4-hydroxyphenyl)propane. 2380 g of N-methyl-2-pyrrolidone was added to dissolve the mixture. The mixture was reacted at 75°C for 16 hours using an oil bath.

Next, 48.20 g (0.280 mol) of 4-ethynylphthalic anhydride dissolved in 190 g of N-methyl-2-pyrrolidone was added and the mixture was stirred for a further three hours to complete the reaction. The reaction mixture was filtered and poured into a 3:1 (volume ratio) mixture of water and iso-propanol. The resulting precipitate collected by filtration was sufficiently washed with water and dried under vacuum to obtain an alkali-soluble resin (A-13) ("polyamide resin with randomly copolymerized structural units of the formulas (4-1), (4-2), and (4-3)") having a cyclization rate satisfying the equations {a/(a+b)}×100=0 and {b/(a+b)}×100=100. The alkali-soluble resin (A-13) had a number average molecular weight of 8100 and consisted of the compounds shown in Table 1.

A photosensitive resin composition was prepared in the same manner as in Example 1, except for changing the amount of the photosensitizer having a structure of the formula (Q-1) to 16 g.

The resulting photosensitive resin composition was evaluated in the same manner as in Example 1, except that in the sensitivity evaluation the developing time by the paddle development was adjusted so that the film thickness difference before and after prebaking was 1 µm.

### <Comparative Example 3>

A four-neck separable flask equipped with a thermometer, a stirrer, a raw material inlet port, and a dry nitrogen gas feed pipe was charged with 433.36 g (0.880 mol) of a dicarboxylic acid derivative (active ester), which was obtained by reacting 0.880 mol of diphenylether-4,4'-dicarboxylic acid and 1.760 mol of 1-hydroxy-1,2,3-benzotriazole, 146.50 g (0.400 mol) of hexafluoro-2,2-bis(3-amino-4-hydroxyphenyl)propane, and 139.35 g (0.600 mol) of bis(3-amino-4-hydroxyphenyl)ether. 2870 g of N-methyl-2-pyrrolidone was added to dissolve the mixture. The mixture was reacted at 75°C for 16 hours using an oil bath.

Next, 41.31 g (0.240 mol) of 4-ethynylphthalic anhydride dissolved in 170 g of N-methyl-2-pyrrolidone was added and the mixture was stirred for a further three hours to complete the reaction. The reaction mixture was filtered and poured into a 3:1 (volume ratio) mixture of water and iso-propanol. The resulting precipitate collected by filtration was sufficiently washed with water and dried under vacuum to obtain an alkali-soluble resin (A-14) ("polyamide resin with randomly copolymerized structural units of the formulas (4-1), (4-2), and (4-3)") having a cyclization rate satisfying the equations {a/(a+b)}×100=0 and {b/(a+b)}×100=100. The alkali-soluble resin (A-14) had a number average molecular weight of 10,200 and consisted of the compounds shown in Table 1.

A photosensitive resin composition was prepared in the same manner as in Example 1.

The resulting photosensitive resin composition was evaluated in the same manner as in Example 1, except that in the sensitivity evaluation the developing time by the paddle method was adjusted so that the film thickness difference before and after prebaking was 1 µm.

### <Comparative Example 4>

A four-neck separable flask equipped with a thermometer, a stirrer, a raw material inlet port, and a dry nitrogen gas feed pipe was charged with 392.69 g (0.880 mol) of a dicarboxylic acid derivative (active ester), which was obtained by reacting 0.440 mol of isophthalic acid, 0.440 mol of diphenylether-4,4'-dicarboxylic acid, and 1.760 mol of 1-hydroxy-1,2,3-benzotriazole, 146.50 g (0.400 mol) of hexafluoro-2,2-bis(3-amino-4-hydroxyphenyl)propane, and 194.60 g (0.600 mol) of 1,3-bis(4-amino-3-hydroxyplienoxy)benzene 2970 g of N-methyl-2-pyrrolidone was added to dissolve the mixture. The mixture was reacted at 75°C for 16 hours using an oil bath.

Next, 41.31 g (0.240 mol) of 4-ethynylphthalic anhydride dissolved in 160 g of N-methyl-2-pyrrolidone was added and the mixture was stirred for further three hours to complete the reaction. The reaction mixture was filtered and poured into a 3:1 (volume ratio) mixture of water and iso-propanol. The resulting precipitate collected by filtration was sufficiently washed with water and dried under vacuum to obtain an alkali-soluble resin (A-15) ("polyamide resin with randomly copolymerized structural units of the formulas (4-1), (4-2), and (4-3)") having a cyclization rate satisfying the equations {a/(a+b)}×100=0 and {b/(a+b)}×100=100. The alkali-soluble resin (A-15) had a number average molecular weight of 11,300 and consisted of the compounds shown in Table 1.

A photosensitive resin composition was prepared in the same manner as in Example 1, except for changing the amount of the photosensitizer having a structure of the formula (Q-1) to 15 g.

The resulting photosensitive resin composition was evaluated in the same manner as in Example 1, except that in the sensitivity evaluation the developing time by the paddle method was adjusted so that the film thickness difference before and after prebaking was 1 µm.

The above examples and comparative examples are summarized in Tables 1 to 3.

**TABLE 1**

| | Amount | | |
|---|---|---|---|
| | Alkali-soluble resin (100 g) | | Photosensitizes (Q-1) (g) |
| | Amine (mol ratio) | Acid (mol ratio) | |
| Example 1 | 4,4'-methylenebis(2-amino-3,6-dimethylphenol) (1.00) | isophthalic acid (0.264), diphenyl ether-4,4'-dicarboxylic acid (0.616) | 13.5 |
| Example 2 | 4,4'-methylenebis(2-amino-3,6-dimethylphenol) (0.70), 3,3'-diamino-4,4'-dihydroxydiphenyhnethane (0,30) | isophthalic acid (0.264), diphenyl ether-4,4'-dicarboxylic acid (0.616) | 13.5 |
| Example 3 | 4,4'-methylenebis(2-amino-3,6-dimethylphenol) (0.70), 2,2-bis(3-amino-4-hydroxyphenyl)propane (0.30) | isophthalic acid (0.264), diphenyl ether-4,4'-dicarboxylic acid (0.616) | 13.5 |
| Example 4 | 4,4'-methylenebis(2-anino-3,6-dimethylphenol) (0.87), 3,3'-diamino-4,4'-dihydroxydiphenylsulfone (0.10), 1,3-bis(3-aminopropyl)tetramethyldisiloxane (0.03) | isophthalic acid (0.435), diphenyl ether-4,4'-dicarboxylic acid (0.435) | 13.5 |
| Example 5 | 4,4'-methylenebis(2-amino-3,6-dimethylphenol) (0.50), hexafluoro-2,2-bis(3-amino-4-hydroxyphenyl)propane (0.50) | diphenyl ether-0,4'-dicarboxylic acid (0.704), 4,4'-oxydiphthalic anhydride (0.176) | 13.5 |
| Example 6 | 4,4'-ethylidenebis(2-amino-3,6-dimethylphenol) (1.00) | isophthalic acid (0.34), diphenyl ether-4,4'-dicarboxylic acid (0.52) | 12.5 |
| Example 7 | 4,4'-ethylidenebis(2-amino-3,6-dimethylphenol) (0.70), 3,3'-diamino-4,4'-dihydroxydiphenylmethane (0.30) | isophthalic acid (0.25), diphenyl ether-4,4'-dicarboxylic acid (0.59) | 14.0 |
| Example 8 | 4,4'-ethylidenebis(2-amino-3,6-dimethylphenol) (0.70), 2,2-bis(3-amino-4-hydroxyphenyl)propane (0.30) | isophthalic acid (0.25), diphenyl ether-4,4'-dicarboxylic acid (0.59) | 14.0 |
| Example 9 | 4,4'-ethylidenebis(2-amino-3,methyl-6-cyclohexylphenol) (1.00) | isophthalic acid (0.34), diphenyl ether-4,4'-dicarboxylic acid (0.50) | 15.0 |
| Example 10 | hexafluoro-2,2-bis(3-amino-4-hydroxyphenyl)propane (0.70), bis(3-amino-4-hydroxyphenyl)ether (0.30) | adipic acid (0.43), diphenyl ether-4,4'-dicarboxylic acid (0.43) | 22.0 |
| Example 11 | hexafluoro-2,2-bis(3-amino-4-hydroxypheny)propane (1.00) | isophthalic acid (0258), diphenyl ether-0,4'-dicarboxylic acid (0.258), 1,3-bis(4-carboxyphenyl)-1,1,3,3-tetrantethyldisiloxane (0.344) | 16.0 |
| Comparative Example 1 | hexafluoro-2,2-bis(3-amino-4-hydroxyphenyl)propane (0.70), 2,2-bis(3-amino-4-hydroxyphenyl)propane (0.30) | isophthalic acid (0.264), diphenyl ether-4,4'-dicarboxylic acid (0.616) | 13.5 |
| Comparative Example 2 | 3,3'-diamino-4,4'-dihydroxydiphenylsulfone (0.70) 3,3'-diamino-4,4'-dihydroxydiphenylmethane (0.30) | isophthalic acid (0264), diphenyl ether-4,4'-dicarboxylic acid (0.616) | 13.5 |
| Comparative Example 3 | hexafluoro-2,2-bis(3-amino-4-hydroxyphenyl)propane (0.40), bis(3-amino-4-hydroxyphenyl)ether (0.60) | diphenyl ether-0,4'-dicarboxylic acid (0.880) | 13.5 |
| Comparative Example 4 | hexafluoro-2,2-bis(3-amino-4-hydroxyphenyl)propane (0.40), 1,3-bis(4-amino-3-hydroxyphenoxy)benzene(0.60) | isophthalic acid (0.440), diphenyl ether-4,4'-dicarboxylic acid (0.440) | 15.0 |

**TABLE2**

| | Photosensitizer (Q-1) (g) | Properties | | | | | | | | | | |
|---|---|---|---|---|---|---|---|---|---|---|---|---|
| | | Transmittance (%) | Alkali-soluble resin cyclization rate (%) | | [A]/[B] | Sensitivity (mJ/cm²) | Photosensitive resin composition cyclization rate (%) | | Water absorption (%) | | | Tg (°C) |
| | | | 250°C [A] | 300°C[B] | | | 250°C | 300°C | 250°C | 300°C | 350°C | |
| Example 1 | 13.5 | 65 | 82 | 100 | 0.82 | 230 | 96 | 100 | 0.7 | 0.6 | 0.5 | 265 |
| Example 2 | 13.5 | 48 | 77 | 97 | 0.79 | 250 | 92 | 100 | 0.8 | 0.6 | 0.5 | 259 |
| Example 3 | 13.5 | 43 | 74 | 98 | 0.76 | 250 | 90 | 100 | 0.8 | 0.6 | 0.5 | 268 |
| Example 4 | 13.5 | 64 | 77 | 99 | 0.78 | 280 | 94 | 100 | 0.8 | 0.7 | 0.6 | 252 |
| Example 5 | 13.5 | 65 | 72 | 95 | 0.76 | 230 | 89 | 100 | 0.9 | 0.6 | 0.5 | 250 |
| Example 6 | 12.5 | 62 | 81 | 99 | 0.81 | 290 | 97 | 100 | 0.5 | 0.5 | 0.5 | 288 |
| Example 7 | 14.0 | 49 | 77 | 98 | 0.78 | 310 | 93 | 100 | 0.7 | 0.4 | 0.4 | 276 |
| Example 8 | 14.0 | 47 | 74 | 99 | 0.75 | 300 | 91 | 100 | 0.7 | 0.4 | 0.4 | 280 |
| Example 9 | 15.0 | 55 | 74 | 99 | 0.74 | 320 | 89 | 100 | 0.7 | 0.5 | 0.5 | 280 |
| Example 10 | 22.0 | 46 | 83 | 94 | 0.89 | 320 | 93 | 96 | 0.8 | 0.7 | 0.7 | 225 |
| Example 11 | 16.0 | 53 | 71 | 95 | 0.75 | 300 | 99 | 99 | 0.4 | 0.3 | 0.3 | 242 |
| Comparative Example 1 | 13.5 | 51 | 44 | 84 | 0.52 | 320 | 57 | 93 | 1.1 | 0.5 | 0.4 | 252 |
| Comparative Example 2 | 13.5 | 57 | 60 | 91 | 0.66 | 260 | 74 | 96 | 1.8 | 1.4 | 1.2 | 256 |
| Comparative Example 3 | 13.5 | 23 | 64 | 95 | 0.68 | 450 | 81 | 100 | 1.1 | 0.7 | 0.7 | 260 |
| Comparative Example 4 | 15.0 | 19 | 67 | 99 | 0.68 | 420 | 85 | 100 | 0.9 | 0.4 | 0.4 | 237 |

**TABLE 3**

| | Water absorption (%) | | | Difference between maximum water absorption and minimum water absorption (%) | Evaluation |
|---|---|---|---|---|---|
| | 250°C | 300°C | 350°C | | |
| Example 1 | 0.7 | 0.6 | 0.5 | 0.2 | Good |
| Example 2 | 0.8 | 0.6 | 0.5 | 0.3 | Good |
| Example 3 | 0.8 | 0.6 | 0.5 | 0.3 | Good |
| Example 4 | 0.8 | 0.7 | 0.6 | 0.2 | Good |
| Example 5 | 0.9 | 0.6 | 0.5 | 0.4 | Good |
| Example 6 | 0.5 | 0.5 | 0.5 | 0.0 | Good |
| Example 7 | 0.7 | 0.4 | 0.4 | 0.3 | Good |
| Example 8 | 0.7 | 0.4 | 0.4 | 0.3 | Good |
| Example 9 | 0.7 | 0.5 | 0.5 | 0.2 | Good |
| Example 10 | 0.8 | 0.7 | 0.7 | 0.1 | Good |
| Example 11 | 0.4 | 0.3 | 0.3 | 0.1 | Good |
| Comparative Example 1 | 1.1 | 0.5 | 0.4 | 0.7 | Bad |
| Comparative Example 2 | 1.8 | 1.4 | 1.2 | 0.6 | Bad |
| Comparative Example 3 | 1.1 | 0.7 | 0.7 | 0.4 | Bad |
| Comparative Example 4 | 0.9 | 0.4 | 0.4 | 0.5 | Bad |

In Table 3, the composition in which the difference between the maximum water absorption and the minimum water absorption is less than 0.5% and the maximum water absorption is not more than 1% was judged as "Good", and the composition in which the difference between the maximum water absorption and the minimum water absorption is not less than 0.5% or the maximum water absorption is more than 1% was judged as "Bad".

As shown in Tables 1 and 2, the composition of Examples 1 to 11 had high transparency and high sensitivity, exhibited only a small fluctuation of the cyclization rate at a wide range of temperatures, and, in addition, exhibited a high cyclization rate and a high Tg when cured at a low temperature of 250°C.

As shown in Table 3, the cured films of Examples 1 to 11 exhibited not only a water absorption of 1% or less even when cured at a wide range of temperatures, but also showed only a very small difference change of less than 0.5% in the water absorptions. Thus, the composition showed constant and stable properties over a wide range of temperatures, suggesting an effect of promoting the productivity of semiconductor device manufacturing.

Semiconductor devices can be produced by applying the photosensitive resin compositions obtained in the above Examples and Comparative Examples to semiconductor elements to form a pattern and forming protective films by curing the coatings in an oven in the same manner as in Example 1.

The semiconductor devices obtained in this manner are expected to operate normally. The semiconductor devices produced by using the photosensitive resin compositions of Examples 1 to 11 are expected to operate with higher reliability than those produced by using the photosensitive resin compositions of the Comparative Examples because of their lower water absorption.

### INDUSTRIAL APPLICABILITY

According to the present invention, a photosensitive resin composition which is highly sensitive and has high productivity in the manufacture of semiconductor devices, a cured film, a protective film, an insulating film, and a semiconductor device and a display device using these films can be provided.

## Claims

1. A photosensitive resin composition comprising an alkali-soluble resin having a polybenzoxazol precursor structure or a polyimide precursor structure, or both, and a photosensitizer, the alkali-soluble resin having a ratio ([A]/[B]) of a cyclization rate [A] (%) at 250°C to a cyclization rate [B] (%) at 300°C of 0.70 or more.

2. The photosensitive resin composition according to claim 1, wherein the cyclization rate of the alkali-soluble resin at 250°C is 70% or more.

3. The photosensitive resin composition according to claim 1 or 2, wherein a film obtained by coating the alkali-soluble resin and drying the coating has a transmittance of light at a wavelength of 365 nm of 40% or more per 5 µm of the film thickness.

4. A cured film comprising a cured product of the photosensitive resin composition according to any one of claims 1 to 3.

5. The cured film according to claim 4, the cured film having a glass transition temperature of 250°C or more.

6. A protective film comprising the cured film according to claim 4 or 5.

7. An insulating film comprising the cured film according to claim 4 or 5.

8. A semiconductor device comprising the cured film according to claim 4 or 5.

9. A display device comprising the cured film according to claim 4 or 5.
